Europäisches Patentamt

**(19)** European Patent Office

Office européen des brevets

**(11)** Publication number : **0 407 127 B1**

## **(12)** EUROPEAN PATENT SPECIFICATION

**(45)** Date of publication of patent specification :
20.09.95 Bulletin 95/38

**(51)** Int. Cl.⁶ : **G06F 11/26**

**(21)** Application number : **90307213.0**

**(22)** Date of filing : **02.07.90**

**(54) Mode programmable VLSI data registers.**

**(30)** Priority : **03.07.89 US 375076**

**(43)** Date of publication of application :
**09.01.91 Bulletin 91/02**

**(45)** Publication of the grant of the patent :
**20.09.95 Bulletin 95/38**

**(84)** Designated Contracting States :
**BE DE ES FR GB IT NL**

**(56)** References cited :
**FIRST EUROPEAN TEST CONFERENCE, PARIS, FRANCE April 12-14, 1989, R. P. VAN RIESSEN ET AL: Design and Implementation of a Hierarchical TestableArchitecture using the Boundary Scan Standard , pp. 112-118**

**(56)** References cited :
**IEEE TRANSACTIONS ON COMPUTER-AIDED DESIGN OF INTEGRATED CIRCUITS AND SYSTEMS vol. 7, no. 12, December 1988, NEW YORK, USA pages 1250 - 1260; K. K. SALUJA ET AL: 'A Concurrent Testing Technique for Digital Circuits '**
**INTERNATIONAL JOURNAL OF ELEC-TRONICS vol. 66, no. 6, June 1989, LONDON, GB; pages 875-878; N.K.NANDA et al.: "Shift Register Modification for Multipurpose Use in Combinational Circuit Testing"**
**IEEE TRANSACTIONS ON INDUSTRIAL ELEC-TRONICS vol. 36, no. 2, May 1989, NEW YORK,USA pages 129 - 140; H. T. NAGLE ET AL: 'Design for Testability and Built-InSelf Test: A Review '**

**(73)** Proprietor : **RAYTHEON COMPANY**
**141 Spring Street**
**Lexington Massachusetts 02173 (US)**

**(72)** Inventor : **Lewis, Edward T.**
**272 Concord Road**
**Sudbury, Massachusetts (US)**

**(74)** Representative : **Jackson, David Spence et al**
**REDDIE & GROSE**
**16, Theobalds Road**
**London, WC1X 8PL (GB)**

## Description

Background of the Invention

This invention relates generally to the testing of very large scale integrated (VLSI) circuits and in particular to mode programmable data registers for performing on-chip self-test in a semiconductor device.

With the increasing complexity of VLSI chips, most modern design approaches are hierarchical and modular in concept. In such cases the chip design generally results in groups of reasonably large functional elements that are interconnected in a "pipeline" format through data storage or transfer registers. In fact the main inputs to and outputs from the chip are parallel data registers. Considering the complexity of such chips, the overall testing using the I/O ports as an interface to large commercial testers represents a formidable task.

Considering the amount of combinatorial logic being exercised in a VLSI chip and the myriad of possible fault modes, it has been estimated by many skilled in the art that millions of test generated inputs and observed outputs must be accomplished in order to state with confidence that a semiconductor chip is "good". Because of this, a great deal of attention has been given in the past few years to techniques for most optimally and efficiently testing a VLSI chip. Various techniques are described in "Built-In Self-Test Techniques" by Edward J. McCluskey, IEEE Design and Test of Computers, Vol. 2, No. 2, pp. 21-28, April 1985.

One such technique involves an approach for chip "self-test". In fact, it is a modern version of a technique devised earlier and applied to module-level testing of functional elements at the printed-circuit board, or higher levels. Using this technique, a series of Pseudo-Random Numbers (PRN) is applied to a functional element or elements and the response is cumulatively observed using a process of data compression or "Signature Analysis", SA.

With respect to applying the on-chip self-test technique to testing a VLSI chip, the current approach is to include the PRN generation on the chip as well as the signature analysis (SA). These elements are designed separately, and during the chip design appropriate control logic is included so that, when in a self-test mode, the PRN can be directed to any data register and the signature analyzer can collect data from any register. Typically, PRN generators are inserted serially to data registers and SA receivers capture data either serially or in parallel. After a number of pre-determined PRN inputs and SA data compressions, the results resident in the SA receiver are compared to a previously determined (from logic simulation) "signature".

The circuits for PRNG, SA, control, and known results are generally incorporated on a section of the chip and called the "chip testability logic" (CTL). Considering the amount of secondary function the CTL must accomplish, it generally tends to consume a large fraction of the usable area on the chip (20% or greater), thereby decreasing the area available for the primary function of the chip. The present invention is defined by Claims 1 and 6 hereinafter, to which reference should now be made.

A preferred embodiment of the present invention, as defined in Claim 1, a mode programmable data register is provided for facilitating on-chip self-test of VLSI circuits with minimum increase in useable VLSI chip areas. Such a data register includes a pseudo-random number (PRN) mode of operation or a signature analysis (SA) mode of operation in addition to a standard data storage and transfer mode of operation and a scan mode of operation. The data register having a PRN mode of operation and the data register having a SA mode of operation are included on a VLSI chip to accomplish the on-chip self-test. The preferred mode programmable data register has automatic data initialization of the stages when operating in the test mode. In addition, each of the plurality of stages comprises logic means coupled to the output of the first register control means for selecting a data mode input or a test mode initialization input for storing in said stages. The mode programmable data register further comprises automatic data initialization of the stages when operating in the test mode.

In a method according to the invention, the step of storing data in a plurality of stages preferably further comprises selecting a data mode input or a test mode initialization input for coupling to each of the plurality of stages with means coupled to the output of the first register control means. Preferably, the step of enabling one of a plurality of modes includes a pseudo-random number generator mode of operation of the data register, or a signature analysis mode of operation of the data register.

Brief Description of the Drawings

FIG. 1 is a logic/circuit diagram of a first embodiment of the invention showing a multistage, mode programmable, multifunctional, CMOS data register comprising a pseudo-random number generator.

FIG. 2 is a schematic diagram of a second embodiment of the invention showing a multistage, mode programmable, multifunctional, CMOS data register comprising a signature analysis capability.

FIG. 3 is a test mode timing diagram for a multifunctional data register having a pseudo-random number generator or a signature analysis capability.

Description of the Preferred Embodiment

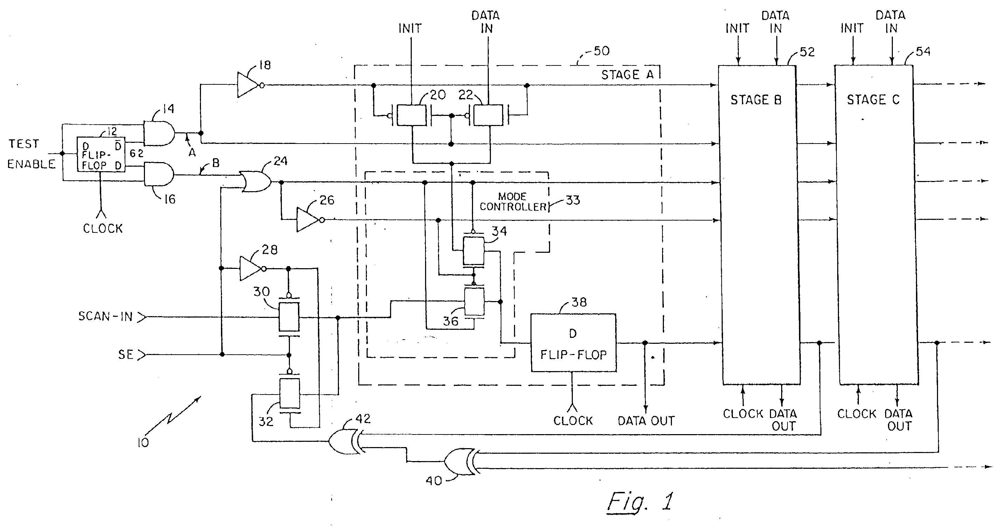

Referring to FIG. 1, there is shown a logic/circuit diagram of an embodiment comprising a mode programmable, multistage, VLSI data register 10 having a pseudo-random number (PRN) generator mode of operation determined by a mode controller 33. In addition, the data register 10 performs normal data storage of transfers data and also operates in a scan mode. A D flip-flop 38 provides the storage capability in stage A 50 and each of the succeeding stages such as stage B 52 and stage C 54 comprises the same circuitry as stage A 50.

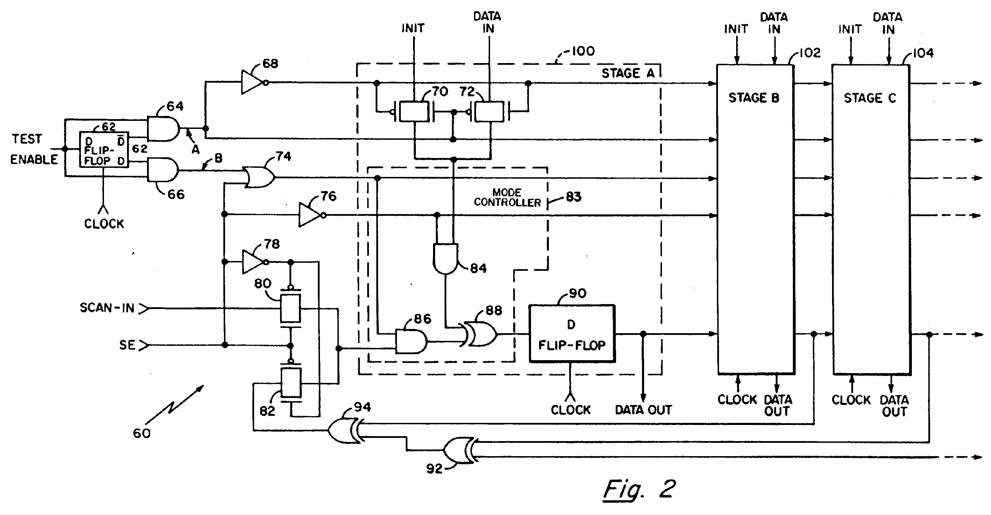

Referring now to FIG. 2, there is shown a logic/circuit diagram of an embodiment comprising a mode programmable, multistage, VLSI data register 60 having a signature analysis (SA) capability in one of its modes of operation determined by a mode controller 83. In addition, the data register 60 performs normal data storage or transfers data and also operates in a scan mode. A D flip-flop 90 provides the storage capability in stage A 100 and each of the succeeding stages such as stage B 102 and stage C 104 comprises the same circuitry as stage A 100. The combination of suing a plurality of mode programmable data registers 10 and mode programmable data registers 60 in place of standard data storage or transfer registers on the same semiconductor chip provides a complete on-chip self-test capability with only very minor increase in chip area for test circuitry.

Referring again to FIG. 1, data is provided to data register 10 via DATA-IN inputs. Table 1 shows the truth table for the three modes of operation for data register 10.

TABLE 1

| MODE | TEST ENABLE (TE) | SCAN ENABLE (SE) |
|------|------------------|------------------|
| Data | 0 | 0 |
| PRN | 1 | 0 |
| Scan | X | 1 |

In the data mode the test enable (TE) signal is a logic zero and the scan enable (SE) signal is a logic zero. In the pseudo-random number generator mode TE is a logic 1 and SE is a logic 0, and to be in the scan mode TE may be either a logic 1 or a logic 0 but SE must be a logic 1. Table 1 shows that while in either a test mode (PRN) or data mode, the data register 10 can be placed in a scan mode so that the contents of the data register can be shifted out to a SCAN output receiver (not shown) for observation.

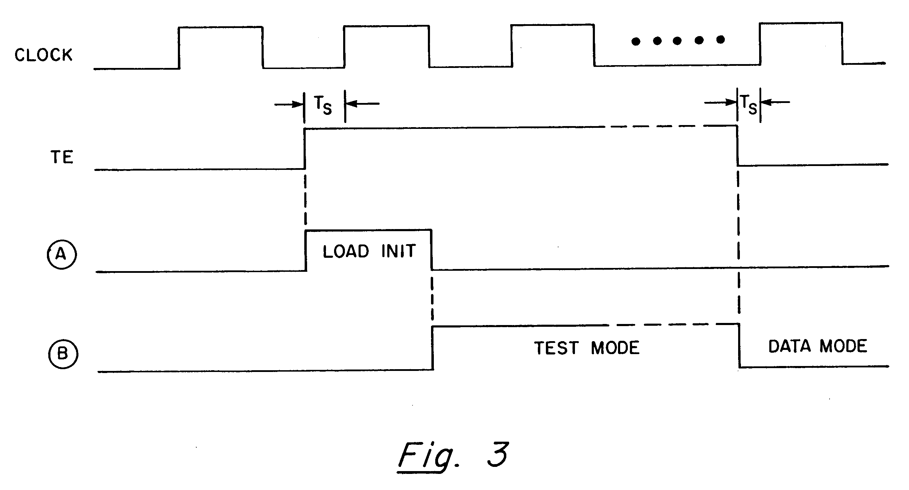

Each stage 50, 52, 54 of the data register 10 has the same circuitry comprising CMOS transmission gates 20, 22 for selecting either a test mode initialization (INIT) input or a data mode input (DATA IN) for coupling to D flip-flop 38. There is also the mode controller 33 comprising transmission gates 34,36 for controlling the data to D flip-flop 38 depending on the selected mode of the data register 10. The control circuitry required for each data register 10 is minimal and independent of the number of stages; it comprises a D flip-flop 12 with a $\overline{D}$ output coupled to AND gate 14 and a D output coupled to AND gate 16 for controlling the test mode operation of data register 10. The A output of AND gate 14 and the B output of AND gate 16 are shown in FIG. 3. When test enable (TE) is asserted, the DATA IN is inhibited from loading the D flip-flop 38 of each stage. Instead, D flip-flop 38 is loaded by initialization (INIT) data via transmission gate 34, by a SCAN-IN input via transmission gate 36 when scan enable (SE) is asserted, or by the linear feedback exclusive-or gates 40, 42 when operating in the pseudo-random number generator mode. CMOS transmission gates 30, 32 receive the SCAN-IN, SE and linear feedback signals, and the output of these gates 30, 32 is coupled to transmission gate 36. The output of transmission gate 36 is loaded into D flip-flop 38.

Referring now to FIGS. 1 and 3, one of the most important features of the present invention is the automatic loading of the initialization (INIT) data word. Unless the pseudo-random number (PSN) generation process starts from a known state, the number generation is truly random resulting in no known expected outputs. Therefore, when the test enable (TE) signal is asserted (logic 1), while the CLOCK is low as shown in FIG. 3, the first action is to switch the input from the data mode to the test mode and to enable the initialization (INIT) input. The INIT may be hard-wired or provided by a programmable INIT data generator. The D flip-flop in each stage of the data register 10 is loaded with its respective INIT bit (0 or 1) during the first active CLOCK pulse. This action is shown in FIG. 3 together with a set-up time ($T_s$) which represents the time necessary to move the INIT data into the master section of the D flip-flop 38 (usually <5 ns). When the CLOCK goes to a logic 1 state, the INIT data is transferred to the slave portion of the D flip-flop 38, thereby establishing the data register 10 starting value. When the CLOCK returns to the logic 0 state, the pseudo-random number generator linear feedback loop is enabled. Then on the next CLOCK pulse, the PRN sequence is initiated. The PRN generator mode remains operational until TE changes to the logic 0 state. Then the data register 10 is available to operate in the normal data mode and accept DATA IN at the next CLOCK pulse.

The use of a linear feedback shift register (LFSR) as a pseudo-random number generator for test vector generation is well known to one skilled in the art. For example, in the previously cited McCluskey reference an overview of Built-In-Self-Test (BIST) techniques is provided which describes the advantages of this approach but makes note of the added chip area required for self-test circuitry resulting in decreases in yield and reliability, but such disadvantages are overcome by the present invention.

Referring now to FIG. 2, data is provided to data register 60 via DATA-IN inputs. Table 2 shows the truth table for the three modes of operation for data register 60.

TABLE 2

| MODE | TEST ENABLE (TE) | SCAN ENABLE (SE) |
|---|---|---|
| Data | 0 | O |
| SA | 1 | 0 |
| Scan | X | 1 |

In the data mode the test enable (TE) signal is a logic zero and the scan enable (SE) signal is a logic 0. In the signature analysis (SA) mode TE is a logic 1 and SE is a logic 0, and to be in the scan mode, TE may be either a logic 1 or a logic 0 but SE must be a logic 1. Table 2 shows that while in either a test mode (SA) or data mode, the data register 60 can be placed in a scan mode so that the contents of the data register can be shifted out to a scan output receiver (not shown) for observation.

Each stage 100, 102, 104 of data register 60 has the same circuitry comprising CMOS transmission gates 70, 72 for selecting either a test mode initialization (INIT) input or a data mode input (DATA-IN) to D flip-flop 90 via mode controller 83 comprising AND gates 84,86 and exclusive-or gate 88. The mode controller 83 controls the data to D flip-flop 90. depending on the selected mode of the data register 60. The control circuitry required for each data register 60 is also minimal and independent of the number of stages; it comprises D flip-flop 62 with a $\overline{D}$ output coupled to AND gate 64 and a D output coupled to AND gate 66 for controlling the test mode operation of data register 60. The A output of AND gate 64 and the B output of AND gate 66 are shown in FIG. 3. When test enable (TE) is asserted, the DATA-IN is inhibited from loading the D flip-flop 90 of each stage 100, 102, 104. Instead D flip-flop 90 is loaded by initialization (INIT) data via transmission gate 70 coupled to AND gate 84, by a SCAN-IN input via CMOS transmission gate 80 (which is coupled to AND gate 86 which is coupled to exclusive-or gate 88) when scan enable (SE) is asserted, or by the linear feedback exclusive-or gates 92, 94 when operating in the signature analysis mode. CMOS transmission gates 80, 82 receive the SCAN-IN, SE, and linear feedback signals, and the output of these gates 80, 82 is coupled to AND gate 86 which is coupled to exclusive-or gate 88.

Referring now to FIGS. 2 and 3 one of the most important features of data register 60 is the automatic loading of the initialization (INIT) data word as similarly noted hereinbefore for data register 10. Unless the signature analysis (SA) process starts from a known state, the data compression is truly random with no known expected results. Therefore, when the test enable (TE) signal is activated while the CLOCK is low as shown in FIG. 3, the first action is to switch the input from the data mode to the test mode and to enable the initialization (INIT) input. The INIT may be hard-wired or provided by a programmable INIT data generator. The D flip-flop in each stage of the data register 60 is loaded with its respective INIT bit (0 or 1) during the first active CLOCK pulse. This action is shown in FIG. 3 together with a set-up time ($T_s$) which represents the time necessary to move the INIT data into the master section of the D flip-flop 90 (usually <5 ns). When the CLOCK goes to a logic 1 state, the INIT data is transferred to the slave portion of the D flip-flop 90, thereby establishing the data register 60 starting value. When the CLOCK returns to the logic 0 state, the feedback loop is enabled. Then on the next CLOCK pulse, the SA operation is initiated. The SA mode remains operational until TE changes to the logic 0 state. Then the data register 60 is available to operate in the normal data mode and accept DATA IN at the next CLOCK pulse.

Signature analysis is well known to one skilled in the art and discussed in the previously cited McCluskey reference. The signature to be analyzed is the bit pattern remaining in a register such as the mode programmable data register 60 after a particular bit pattern such as that from a pseudo-random number generator has been applied to the VLSI circuitry under test. The most popular compression circuits employ linear feedback shift registers (LFSR).

To perform on-chip self-test of a VLSI circuit a data register 10 having a pseudo-random number (PRN) generator mode of operation is included on the VLSI chip along with a data register 60 having a signature analysis (SA) mode of operation. The PRN generator data register is typically inserted serially to data registers and the SA data register captures data either serially or in parallel. After a number of pre-determined PRN inputs and SA data compressions, the results resident in the SA register are compared to a previously determined "signature" (from logic simulation).

This concludes the description of the preferred embodiment. However, many modifications and alterations will be obvious to one of ordinary skill in the art without departing from the inventive concept. For example, the initialization (INIT) input to data registers 10, 60 may be hard-wired or provided by a programmable INIT data generator. Therefore, it is intended that the scope of this invention be limited only by the appended claims.

## Claims

1. A mode programmable data register comprising:

    a plurality of stages (50,52,54; 100,102,104) for storing data, each of said stages having a mode control means (33;83) for enabling one of a plurality of modes;

    first register control means (12,14,16; 62,64,66) coupled to said plurality of stages (50,52,54; 100,102,104) for selecting a test mode or a data mode in accordance with a programmed input control signal;

    means (40,42; 92,94) coupled to an output of at least one predetermined stage of said plurality of stages for generating a feedback signal to a first one of said stages when said test mode is selected; and

    second register control means (28,30,32; 78,80,82) coupled to said first register control means and to said feedback signal generating means for selecting a scan mode of said register in accordance with a scan enable signal, characterised in that it further comprises means coupled to said first register control means and each of said stages for automatically initializing the register to one of a plurality of predetermined states in accordance with a parallel initialization input to each stage, said initializing being performed during a first clock period of an enabled one of said plurality of modes following the assertion of said test enable control signal.

2. A mode programmable data register according to claim 1, characterised in that one of said plurality of modes comprises a pseudo-random number generator mode of operation.

3. A mode programmable data register according to claim 1, characterised in that one of said plurality of modes comprises a signature analysis mode of operation.

4. A mode programmable data register according to claim 1, characterised in that said initialisation means in each of said plurality of stages comprises logic means (18; 68) coupled to the output of said first register control means for selecting a data mode input or a test mode initialization input for storing in said stages.

5. A mode programmable data register according to claim 1, characterised in that each of said plurality of stages comprises a flip-flop (38; 90) for storing said data.

6. A method of providing a mode programmable data register on a VLSI chip for on-chip self-testing comprising the steps of:

    storing data in a plurality of stages (50,52,54; 100,102,104) of said data register;

    enabling one of a plurality of modes of said data register with mode control means (33; 83);

    selecting a test mode or a data mode of said data register in accordance with a programmed input control signal with a first register control means (12,14,16; 62,64,66) coupled to said plurality of stages;

generating a feedback signal to couple to a first one of said stages, when said test mode is selected, with means (40,42; 92,94) coupled to an output of at least one predetermined stage of said plurality of stages; and

selecting a scan mode of said data register in accordance with a scan enable signal using a second register control means (28,30,32; 78,80,82) coupled to said first register control means and to said feedback signal generating means said method, characterised in that it further comprises the step of initializing automatically the register to one of a plurality of predetermined states in accordance with a parallel initialization input to each stage during a first clock period of said enabled one of a plurality of modes following the assertion of said test enable control signal.

7. A method according to claim 6, characterised in that said step of storing data in a plurality of stages further comprises selecting a data mode input or a test mode initialization input for coupling to each of said plurality of stages with means (20,22; 70,72) coupled to the output of said first register control means.

8. A method according to claim 6, characterised in that said step of enabling one of a plurality of modes includes a pseudo-random number generator mode of operation of said data register.

9. A method according to claim 6, characterised in that said step of enabling one of a plurality of modes includes a signature anaylsis mode of operation of said data register.


**Patentansprüche**

1. Modusprogrammierbares Datenregister mit
   - einer Mehrzahl von Stufen (50, 52, 54; 100, 102, 104) zum Speichern von Daten, wobei jede der genannten Stufen eine Modussteuereinrichtung (33; 83) zum Wirksamwerdenlassen eines aus einer Mehrzahl von Moden aufweist;
   - ersten Registersteuermitteln (12, 14, 16; 62, 64, 66), die mit der genannten Anzahl von Stufen (50, 52, 54; 100, 102, 104) zur Auswahl eines Testmodus oder eines Datenmodus entsprechend einem programmierten Eingangssteuersignal gekoppelt sind;
   - mit einem Ausgang mindestens einer vorbestimmten Stufe der genannten Anzahl von Stufen gekoppelten Mitteln (40, 42; 92, 94) zur Erzeugung eines Rückkopplungssignals zu einer ersten der genannten Stufen hin, wenn der Testmodus gewählt ist; und
   - einer zweiten Registersteuereinrichtung (28, 30, 32; 78, 80, 82), welche mit der genannten ersten Registersteuereinrichtung und den genannten Mitteln zur Erzeugung eines Rückkopplungssignals verbunden sind, um einen Abtastmodus des Registers entsprechend einem Abtast-Einschaltsignal zu wählen,
   dadurch gekennzeichnet, daß es weiter Mittel enthält, die mit der genannten ersten Registersteuereinrichtung und jeder der Stufen verbunden sind, um automatisch das Register für einen aus einer Mehrzahl vorbestimmter Zustände entsprechend einem Parallel-Initialisierungseingang zu jeder Stufe zu initialisieren, wobei diese Initialisierung während einer ersten Taktperiode eines wirksam geschalteten der genannten Anzahl von Moden nach der Feststellung des Test-Einschaltsteuersignals durchgeführt wird.

2. Modusprogrammierbares Datenregister nach Anpruch 1, dadurch gekennzeichnet, daß einer der genannten Anzahl von Moden eine Betriebsweise entsprechend einem Pseudo-Zufallszahlengenerator umfaßt.

3. Modusprogrammierbares Datenregister nach Anspruch 1, dadurch gekennzeichnet, daß einer der genannten Anzahl von Moden eine Betriebsweise entsprechend einer Signaturanalyse umfaßt.

4. Modusprogrammierbares Datenregister nach Anspruch 1, dadurch gekennzeichnet, daß die Initialisierungsmittel in jeder der genannten Anzahl von Stufen logische Einrichtungen (18, 68) enthalten, die mit dem Ausgang der ersten Registersteuereinrichtung zur Auswahl eines Datenmoduseinganges oder eines Testmodus-Initialisierungseingangs zur Speicherung in den genannten Stufen verbunden sind.

5. Modusprogrammierbares Datenregister nach Anspruch 1, dadurch gekennzeichnet, daß jede der genannten Anzahl von Stufen ein Flip-Flop (38; 90) zur Speicherung der genannten Daten enthält.

**6.** Verfahren zur Schaffung eines modusprogrammierbaren Datenregisters auf einem VLSI-Chip (Chip mit Schaltungsintegration in sehr großem Maßstab) für Selbsttesteigenschaften auf dem Chip mit den folgenden Schritten:

- Speichern von Daten in einer Mehrzahl von Stufen (50, 52, 54; 100, 102, 104) des Datenregisters;
- Wirksamwerdenlassen eines einer Mehrzahl von Moden des Datenregisters durch eine Modussteuereinrichtung (33; 83);
- Auswahl eines Testmodus oder eines Datenmodus des Datenregisters entsprechend einem programmierten Eingangssteuersignal mittels einer ersten Registersteuereinrichtung (12, 14, 16; 62, 64, 66), die mit der genannten Anzahl von Stufen gekoppelt ist;
- Erzeugen eines Rückkopplungssignals zur Kopplung an eine erste der genannten Stufen, wenn der Testmodus ausgewählt ist, vermittels Einrichtungen (40, 42; 92, 94), die mit einem Ausgang mindestens einer vorbestimmten Stufe der genannten Mehrzahl von Stufen verbunden sind; und
- Auswahl eines Abtastmodus des genannten Datenregisters in Entsprechung mit einem Abtast-Einschaltsignal unter Verwendung einer zweiten Registersteuereinrichtung (28, 30, 32; 78, 80, 82), die an die erste Registersteuereinrichtung und die Mittel zur Erzeugung des Rückkopplungssignals angekoppelt ist,

wobei das Verfahren dadurch gekennzeichnet ist, daß es weiter den Schritt der automatischen Initialisierung des Registers für einen aus einer Anzahl vorbestimmter Zustände entsprechend einem parallelen Initialisierungseingang zu jeder Stufe während einer ersten Taktperiode des wirksam geschalteten aus einer Mehrzahl von Moden nach der Feststellung des Test-Einschaltsteuersignals umfaßt.

**7.** Verfahren nach Anspruch 6, dadurch gekennzeichnet, daß der genannte Schritt der Speicherung von Daten in einer Anzahl von Stufen weiter die Auswahl eines Datenmoduseingangs oder eines Testmodus-Initialisierungseingangs zur Ankopplung an jede der genannten Anzahl von Stufen durch Einrichtungen (20, 22; 70, 72) umfaßt, die mit dem Ausgang der ersten Registersteuereinrichtung gekoppelt sind.

**8.** Verfahren nach Anspruch 6, dadurch gekennzeichnet, daß der Schritt des Wirksamwerdenlassens eines einer Anzahl von Moden eine Betriebsweise des Datenregisters entsprechend einem Pseudo-Zufallszahlengenerator umfaßt.

**9.** Verfahren nach Anspruch 6, dadurch gekennzeichnet, daß der Schritt des Wirksamwerdenlassens eines aus einer Anzahl von Moden eine Betriebsweise des Datenregisters entsprechend einer Signaturanalyse umfaßt.

**Revendications**

**1.** Registre de données programmable selon des modes, comprenant :

une pluralité d'étages (50, 52, 54 ; 100, 102, 104) pour mémoriser des données, chacun desdits étages possèdant des moyens de commande de mode (33 ; 83) pour valider l'un de la pluralité de modes ;

des premiers moyens de commande de registre (12, 14, 16 ; 62, 64, 66) couplés à ladite pluralité d'étages (50, 52, 54 ; 100, 102, 104) pour sélectionner un mode de contrôle ou un mode de données en fonction d'un signal de commande d'entrée programmé ;

des moyens (40, 42 ; 92, 94) couplés à une sortie d'au moins un étage prédéterminé de ladite pluralité d'étages pour générer un signal de contre-réaction au premier desdits étages lorsque ledit mode de contrôle est sélectionné ; et

des seconds moyens de commande de registre (28, 30, 32 ; 78, 80, 82) couplés auxdits premiers moyens de commande de registre et auxdits moyens de génération de signal de contre-réaction pour sélectionner un mode de balayage dudit registre en fonction d'un signal de validation de balayage, caractérisé en ce qu'il comprend en outre des moyens couplés auxdits premiers moyens de commande de registre et à chacun desdits étages pour initialiser automatiquement le registre à l'un d'une pluralité d'états prédéterminés en fonction d'une entrée d'initialisation parallèle de chaque étage, ladite initialisation étant exécutée au cours d'une première période d'horloge de l'un, validé, de ladite pluralité de modes, suivant l'assertion dudit signal de commande de validation de contrôle.

**2.** Registre de données programmable selon des modes selon la revendication 1, caractérisé en ce que l'un de ladite pluralité de modes comprend un mode de fonctionnement par génération de nombres pseudo-alétoires.

3. Registre de données programmable selon des modes selon la revendication 1, caractérisé en ce que l'un de ladite pluralité de modes comprend un mode de fonctionnement par analyse de réponses logiques.

4. Registre de données programmable selon des modes selon la revendication 1, caractérisé en ce que lesdits moyens d'initialisation de chacun de ladite pluralité d'étages comprennent des moyens logiques (18 ; 68) couplés à la sortie desdits premiers moyens de commande de registre pour sélectionner une entrée de mode de données ou une entrée d'initialisation de mode de contrôle à mémoriser dans lesdits étages.

5. Registre de données programmable selon des modes selon la revendication 1, caractérisé en ce que chacun de ladite pluralité d'étages comprend une bascule (38 ; 90) pour mémoriser lesdites données.

6. Procédé pour réaliser un registre de données programmable selon des modes sur une puce VLSI pour un autocontrôle de la puce, comprenant les étapes consistant à :
mémoriser les données dans une pluralité d'étages (50, 52, 54 ; 100, 102, 104) dudit registre de données ;
valider l'un de ladite pluralité de modes dudit registre de données avec les moyens de commande de mode (33 ; 83) ;
sélectionner un mode de contrôle ou un mode de données dudit registre de données en fonction d'un signal de commande d'entrée programmé avec des premiers moyens de commande de registre (12, 14, 16 ; 62, 64, 66) couplés à ladite pluralité d'étages ;
générer un signal de contre-réaction pour coupler le premier desdits étages, lorsque ledit mode de contrôle est sélectionné, à des moyens (40, 42 ; 92, 94) couplés à une sortie d'au moins un étage prédéterminé de ladite pluralité d'étages ; et
sélectionner un mode de balayage dudit registre de données en fonction d'un signal de validation de balayage en utilisant des seconds moyens de commande de registre (28, 30, 32 ; 78, 80, 82) couplés auxdits premiers moyens de commande de registre et auxdits moyens de génération de signal de contre-réaction, ledit procédé étant caractérisé en ce qu'il comprend en outre l'étape consistant à initialiser automatiquement le registre à l'un de la pluralité des états prédéterminés en fonction d'une entrée d'initialisation parallèle de chaque étage au cours d'une première période d'horloge dudit mode validé de la pluralité de modes suivant l'assertion dudit signal de commande de validation de contrôle.

7. Procédé selon la revendication 6, caractérisé en ce que ladite étape consistant à mémoriser les données dans une pluralité d'étages, comprend en outre la sélection d'une entrée de mode de données ou d'une entrée d'initialisation de mode de contrôle pour coupler chacun de ladite pluralité d'étages avec des moyens (20, 22 ; 70, 72) couplés à la sortie desdits premiers moyens de commande de registre.

8. Procédé selon la revendication 6, caractérisé en ce que ladite étape consistant à valider l'un de la pluralité de modes comprend un mode de fonctionnement dudit registre de données par génération de nombres pseudo-alétoires.

9. Procédé selon la revendication 6, caractérisé en ce que ladite étape consistant à valider l'un de la pluralité de modes comprend un mode de fonctionnement dudit registre de données par analyse de réponses logiques.

_Fig. 1_

_Fig. 2_

CLOCK

$T_S$

TE

A  LOAD INIT

B  TEST MODE  DATA MODE

$T_S$

_Fig. 3_